(19) Europäisches Patentamt
European Patent Office
Office européen des brevets

(11) EP 2 404 163 B1

(12) **EUROPÄISCHE PATENTSCHRIFT**

(45) Veröffentlichungstag und Bekanntmachung des Hinweises auf die Patenterteilung:
**27.11.2013 Patentblatt 2013/48**

(21) Anmeldenummer: **10716269.5**

(22) Anmeldetag: **23.02.2010**

(51) Int Cl.:
***G01N 22/00*** *(2006.01)* ***G01R 27/26*** *(2006.01)*
***H01P 7/04*** *(2006.01)*

(86) Internationale Anmeldenummer:
**PCT/DE2010/000200**

(87) Internationale Veröffentlichungsnummer:
**WO 2010/099778 (10.09.2010 Gazette 2010/36)**

# (54) HALBOFFENE RESONATORANORDNUNG IN FORM EINES TOPFKREISES UND VERFAHREN ZUR UNTERSUCHUNG EINER PROBE MIT DER RESONATORANORDNUNG

SEMI-OPEN RESONATOR ASSEMBLY IN THE FORM OF A REENTRANT CAVITY AND METHOD FOR ANALYZING A SAMPLE USING THE RESONATOR ASSEMBLY

DISPOSITIF RÉSONATEUR SEMI-OUVERT EN FORME D'UNE CAVITÉ RÉENTRANTE ET PROCÉDÉ D'EXAMEN D'UN ÉCHANTILLON AU MOYEN DU DISPOSITIF RÉSONATEUR

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **02.03.2009 DE 102009011069**
**02.03.2009 US 208937 P**

(43) Veröffentlichungstag der Anmeldung:
**11.01.2012 Patentblatt 2012/02**

(73) Patentinhaber: **Forschungszentrum Jülich GmbH**
**52425 Jülich (DE)**

(72) Erfinder:
- **KLEIN, Norbert**
**Staines Middx, TW18 4LB (GB)**
- **VITUSEVICH, Svetlana**
**52353 Düren (DE)**
- **DANYLYUK, Serhiy**
**52428 Jülich (DE)**

(56) Entgegenhaltungen:

| | |
|---|---|
| **EP-A1- 1 371 978** | **EP-A2- 1 091 441** |
| **WO-A2-2008/040305** | **DE-A1- 2 328 590** |
| **JP-A- 2 272 349** | **JP-A- 54 010 796** |
| **JP-A- 55 069 043** | **US-A- 4 103 224** |

- **EBBE NYFORS AND PERTTI VAINIKAINEN: "INDUSTRIAL MICROWAVE SENSORS", INDUSTRIAL MICROWAVE SENSORS, 1. Januar 1989 (1989-01-01), XP002334964,**
- **R.J.King: "Chapter 5 On-line Industrial Applications of Microwave Moisture Sensors" In: H. Baltes, W.Göpel, J. Hesse (Editors), K. Kupfer, A. Kraszewski, R. Knöchel (Guest Editors): "Sensors Update, Special Topic: RF & Microwave Sensing of Moist Materials", 2000, Wiley-VCH, Weinheim, XP002601615, ISBN: 3-527-29821-5 Bd. 7, Seiten 109-170, Seite 145 - Seite 147; Abbildungen 5.16, 5.18**
- **KRAUSE H-J ET AL: "Dielectric microwave resonator for non-destructive evaluation of moisture and salinity", 9TH EUROPEAN CONFERENCE ON NDT: ECNDT BERLIN 2006; SEPTEMBER 25 - 29, 2006, EUROPEAN FEDERATION FOR NON-DESTRUCTIVE TESTING, BERLIN, 29. September 2006 (2006-09-29), Seiten 1-12, XP008104806, ISBN: 978-3-931381-86-8**
- **KRZYSZTOF A. MICHALSKI: "Chapter 5 "RIGOROUS ANALYSIS METHODS"", DARKO KAJFEZ AND PIERRE GUILLON (EDITORS): "DIELECTRIC RESONATORS", NOBLE PUBLISHING CORPORATION, [Online] 1998, Seiten 185-257, XP002630380, ATLANTA ISBN: 1-884932-05-3 Gefunden im Internet: URL:http://proxy.bookfi.org/genesis1/16500 0/1a2cea8e18f354506db042aa74ea80f1/_as/%5B Darko%20Kajfez%20and%20Pierre%20Guillon% 5D _%EF%BB%BFDielectric%20Resonators (BookFi.o rg).pdf> [gefunden am 2011-03-28]**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

- MATJAZ VALANTA, DANILO SUVOROV, SRECO MACEKA: "Measurement error analysis in the determination of microwave dielectric properties using cavity reflection method", FERROELECTRICS, Bd. 176, 1996, Seiten 167-177, XP9146429, Switzerland ISSN: 0015-0193
- SVETLANA A VITUSEVICH ET AL: "Design and Characterization of an All-Cryogenic Low Phase-Noise Sapphire <maths><tex>$K$</tex></maths>-Band Oscillator for Satellite Communication", IEEE TRANSACTIONS ON MICROWAVE THEORY AND TECHNIQUES, IEEE SERVICE CENTER, PISCATAWAY, NJ, US, Bd. 51, Nr. 1, 1. Januar 2003 (2003-01-01) , XP011076848, ISSN: 0018-9480
- ZHIHONG MA, SEICHI OKAMURA AND TOMOYASU KAWASAKI: "A FUNDAMENTAL STUDY ON MICROSTRIP SENSOR FOR MEASURING WATER CONTENT AND ION CONDUCTIVITY", FOURTH INTERNATIONAL CONFERENCE ON ELECTROMAGNETIC WAVE INTERACTION WITH WATER AND MOIST SUBSTANCES, [Online] 13. Mai 2001 (2001-05-13), - 16. Mai 2001 (2001-05-16), Seiten 462-467, XP002630492, Weimar / Germany Gefunden im Internet: URL:http://www.isema-online.com/uploads/20 01_Proceedings.pdf> [gefunden am 2011-03-29]

## Beschreibung

Die Erfindung bezieht sich auf eine Resonatoranordnung und ein Verfahren zur Untersuchung einer Probe mit der Resonatoranordnung.

Aus DE 102006046657 A1 ist ein Verfahren und eine Vorrichtung zur Untersuchung einer Probe in einem geschlossenen Behälter bekannt. Dabei wird mittels eines halboffenen dielektrischen Resonators die Probe untersucht.

Nachteilig ist mit dieser Vorrichtung und dem darin offenbarten Verfahren eine qualitative Unterscheidung von verschiedenen, chemisch ähnlichen Flüssigkeiten nicht in jedem Fall möglich.

Aufgabe der Erfindung ist es, eine verbesserte Vorrichtung und ein entsprechendes Verfahren zur Identifikation einer Probe bereit zu stellen.

Die Aufgabe wird durch eine Vorrichtung nach Anspruch 1 und ein Verfahren nach Nebenanspruch gelöst. Vorteilhafte Ausgestaltungen ergeben sich aus den darauf rückbezogenen Ansprüchen.

Die Resonatoranordnung umfasst ein leitfähiges, vorzugsweise metallisches halboffenes Gehäuse. Vorzugsweise ist das Gehäuse kreiszylindrisch. Im Gehäuse sind Einkoppelantennen für einen Koaxialresonator angeordnet. Der Koaxialresonator umfasst einen leitfähigen Stab, der koaxial vom metallischen Gehäuse umschlossen ist. Vorzugsweise ist der Stab zentral im Gehäuse angeordnet. Der Stab weitet sich zum Gehäuseboden gerichtet stempel- bzw. plattenförmig auf. Die Plattenform an diesem Ende des Stabs bildet zusammen mit einem Dielektrikum und dem Gehäuseboden selbst, als zweite Platte des Kondensators, einen kapazitiven Abschluss des Koaxialresonators aus. Am gegenüberliegenden Teil des koaxialen Teils des Stabs ist dieser mit dem Gehäuse kurzgeschlossen. Der Stab und das Gehäuse bilden gemeinsam einen LC-Schwingkreis aus.

Vorzugsweise erfolgt der Kurzschluss mit dem Gehäuse durch einen Kurzschlussstab z. B. einen Querbügel, der das obere Stabende mit dem Gehäuse radial verbindet. Diese Anordnung eines Koaxialresonators ist vorteilhaft sehr kompakt. Durch den halboffenen Charakter der Anordnung ist sicher gestellt, dass das Magnetfeld des Kurzschlussstabs für die Leitfähigkeitsmessung einer darüber angeordneten Probe verwendet werden kann.

Vorteilhaft sind die hohen Gütefaktoren, z. B. 700 bei einer Resonanzfrequenz von 100 MHz, die mit dieser Anordnung erzielt werden können, zur Untersuchung einer Probe heranzuziehen.

Erfindungsgemäss ist der koaxiale Stab durch einen vorzugsweise kreiszylindrischen dielektrischen Resonator im Innern des Gehäuses hindurchgeführt. Der Stab und der diesen umgebende dielektrische Resonator sind vorzugsweise zentriert im Gehäuse angeordnet und von diesem wiederum koaxial umschlossen. Dadurch wird besonders vorteilhaft bewirkt, dass nicht nur das magnetische Feld des Querbügels, sondern zudem das elektrische Feld des dielektrischen Resonators gleichzeitig für die Untersuchung einer über dem halboffenen Gehäuse angeordneten Probe verwendet werden können. Hierzu liegen z. B. in der Zylinderwand des Gehäuses Koppelschleifen zur Anregung der Mode des dielektrischen Resonators vor. Hierdurch umfasst die Resonatoranordnung einen Dual-Mode-Resonator. Besonders vorteilhaft wird bewirkt, dass das elektrische Feld des dielektrischen Resonators und das magnetische Feld des Querbügels sich dabei gegenseitig nicht negativ beeinflussen. Dadurch wird eine extrem kompakte Resonatoranordnung bereitgestellt, die eine hochqualitative Unterscheidung von Proben gewährleistet. Vorteilhaft sind in beiden Moden der Resonatoranordnung hohe Gütefaktoren erzielbar. Ferner vorteilhaft ist, dass beide Moden sehr unterschiedliche Resonanzfrequenzen von z. B. 100 MHz und 2 GHz aufweisen können.

Die Resonatoranordnung ist derartig angeordnet, dass der dielektrische Resonator zentriert in dem metallischen Gehäuse angeordnet ist und zusammen mit dem Gehäuse den Stab koaxial umschließt.

Die Resonatoranordnung weist Mittel zur Anregung der koaxialen Mode des LC-Schwingkreises und Mittel zur Anregung von Moden des dielektrischen Resonators auf.

In der Resonatoranordnung wird der dielektrische Resonator zur Bestimmung der dieelektrischen Relaxation bei Frequenzen oberhalb 1 GHz und der kapazitiv abgeschlossene koaxiale Resonator zur Bestimmung der elektrischen Leitfähigkeit bei Frequenzen zwischen etwa 1 bis 500 MHz, vorzugsweise 10 bis 500 MHz, eingesetzt.

Die Moden des dielektrischen Resonators und des LC-Schwingkreises werden simultan angeregt und ein räumlich überlappendes evaneszentes Feld außerhalb der Resonatoranordnung für beide Moden erzeugt. Sodann kann mit der Resonatoranordnung die dielektrische Relaxation und die elektrische Leitfähigkeit zur Analyse der Probe simultan bestimmt werden. Während der Messungen bei beiden Resonanzfrequenzen muss vorteilhaft die Position der Probe gegenüber der Resonatoranordnung nicht mehr verändert werden.

In die Resonatoranordnung wird ein Hochfrequenzsignal zur Anregung der resonanten Mode des dielektrischen Resonators eingekoppelt, die Resonanzkurve mindestens einer resonanten Mode wird gemessen, und aus der ermittelten Veränderung der Resonanzfrequenz im Vergleich zu einer Messung ohne Probenbehälter die Probe identifiziert. Die entsprechende Messung der Resonanzkurve des LC-Schwingkreises soll mit etwa mindestens einer halben Dekade Frequenzunterschied erfolgen.

Die Anregung erfolgt vorzugsweise mit Mikrowellenstrahlung größer 1 GHz für den dielektrischen Resonator bzw. mit Mikrowellenstrahlung im Bereich von etwa 1 bis 500 MHz für den LC-Schwingkreis. Die Güte des LC-Schwingkreises hängt von der Frequenz ab und kann z. B. 700 bei 100 MHz betragen.

Die beiden Moden weisen außerhalb der Resonatoranordnung, besonders bevorzugt an gleicher Stelle, ein räumlich überlappendes evaneszentes Feld, an der die Probe untersucht wird, auf. Dadurch ist gewährleistet, dass Flüssigkeiten selbst in geschlossenen Behältern weitgehend unabhängig von Form und Größe an einem einzigen Messort analysiert werden können. Durch die hohen Gütefaktoren und niedrigen Resonanzfrequenzen der koaxialen Mode lässt sich die elektrische Leitfähigkeit über die Änderung des Gütefaktors sehr genau bestimmen.

Bei Kombination dieser Messungen mit den gemessen Änderungen von Güte und Resonanz-frequenz lassen sich jedwede Proben, das heißt flüssige wie feste, insbesondere, wenngleich nicht beschränkt hierauf, auch solche flüssigen Proben in geschlossenen Behältern durch die dielektrischen Eigenschaften und Leitfähigkeit sehr differenziert und schnell analysieren.

Die erfindungsgemäße Vorrichtung erlaubt beispielsweise eine simultane Anregung einer $TE_{0m,n+\delta}$ Mode eines kreiszylindrischen dielektrischen Resonators und einer in der Resonanzfrequenz deutlich niedriger liegenden kapazitiv abgeschlossenen Koaxialmode.

Es wurde erkannt, dass die Feldverteilung und der Gütefaktor der Mode des dielektrischen Resonators durch den Stempel des Stabs, durch das Dielektrikum und durch die Koppelantennen für die koaxiale Mode in dieser Resonatoranordnung nur sehr wenig beeinflusst werden. Aus diesem Grund kann die Mode zur Identifikation von Flüssigkeiten benutzt werden. Dabei wird die durch die Probe eintretende charakteristische Veränderung des Verhältnisses aus Resonanzfrequenz und Güte, vorzugsweise des Verhältnisses aus Resonanzfrequenz, und reziproker Güte, nach Messung gegen Luft ermittelt.

Auf der anderen Seite wurde ferner erkannt, dass das elektrische Feld der Koaxialmode nahezu vollständig im Spalt zwischen dem Stempel und dem Gehäuseboden konzentriert ist, so dass der dielektrische Resonator lediglich eine geringfügige Frequenz senkende Wirkung hat. Das Magnetfeld des Kurzschlussstabs ragt in den Außenraum, und kann für die Leitfähigkeitmessungen benutzt werden.

Die räumlich überlappenden evaneszenten elektrischen Felder der Mode des dielektrischen Resonators und des magnetischen Feldes der Koaxialmode im Außenraum erlaubt eine Messung der Eigenschaften der Proben bei beiden Resonanzfrequenzen in einer einzigen Position, ohne dass die Position der Probe oder eines Probenbehälters gegenüber der Resonatoranordnung verändert werden muss.

Im Rahmen der Erfindung wurde zudem erkannt, dass die komplexe dielektrische Funktion $\varepsilon(\omega)=\varepsilon_1(\omega)+i\varepsilon_2(\omega)$ als Charakteristikum von Flüssigkeiten, eine Differenzierung auf der Basis unterschiedlicher physikalischer Mechanismen erlaubt. Dabei ermöglicht der Realteil $\varepsilon_1(\omega)$ im Wesentlichen eine Unterscheidung von Flüssigkeiten anhand der elektrischen Polarisierbarkeit und der dielektrischen Relaxation der Moleküle. Daraus ergibt sich vorteilhaft eine sehr einfache Unterscheidung von z. B. wässrigen Flüssigkeiten von organischen Flüssigkeiten.

Insbesondere bei wässrigen Flüssigkeiten ist eine differenzierte Unterscheidung über die elektrische Leitfähigkeit möglich, die von den in der Flüssigkeit vorhandenen Ionen herrührt, und zu einem $1/\omega$ Beitrag zum Imaginärteil $\varepsilon_2(\omega)$ der komplexen dielektrischen Funktion führt:

$$\varepsilon(\omega)=\frac{\varepsilon_S(T)-\varepsilon_\infty(T)}{1+i\omega\tau(T)}+\frac{\sigma}{i\omega\varepsilon_0} \qquad \text{Gl.1}$$

Dabei bezeichnet $\varepsilon_S(T)$ die statische Dielektrizitätskonstante, die z. B. bei Wasser mit Werten um die 80 deutlich oberhalb der Werte aller bekannten organischen Flüssigkeiten liegt. $\varepsilon_\infty(T)$ ist die optische Dielektrizitätskonstante und $\tau(T)$ die stark temperaturabhängige Relaxtionszeit, die für Wasser bei Raumtemperatur bei etwa 6 ps liegt, und damit zu einer starken Frequenzabhängigkeit von $\varepsilon_1(\omega)$ und $\varepsilon_2(\omega)$ führt.

Insbesondere der hohe Wert von $\varepsilon_2(\omega)$ im Mikrowellenbereich mit Maximum bei etwa 20 GHz führt dazu, dass Wasser Mikrowellen sehr stark absorbiert. Dagegen dominiert im Verlauf von $\varepsilon_2(\omega)$ bei Frequenzen unterhalb von etwa 500 MHz der mit sinkender Frequenz zunehmende Beitrag der Ionenleitfähigkeit ($\sigma$ in Gl. 1) bei wässrigen trinkbaren oder kosmetischen Flüssigkeiten gegenüber mit wachsender Frequenz zunehmenden Verlusten durch die molekulare Relaxation der Wassermoleküle. Bei stark salzhaltigen Flüssigkeiten oder starken Säuren und Basen kann diese Dominanz auch bei höheren Frequenzen erhalten bleiben.

Die erfindungsgemäße Anordnung erlaubt z. B. die simultane Anregnung einer $TE_{0m,n+\delta}$ Mode eines kreiszylindrischen Resonators im Mikrowellenbereich (im Ausführungsbeispiel $TE_{01\delta}$ Mode bei 2,2 GHz) mit einer Mode eines kapazitiv abgeschlossenen Koaxialresonators bei wesentlich niedrigen Frequenzen (im Ausführungsbeispiel ca. 100 MHz).

Im Weiteren wird die Erfindung an Hand eines Ausführungsbeispiels und der beigefügten Figur näher beschrieben.

Es zeigen:

Figur 1: Erfindungsgemäße Resonatoranordnung.

Figur 2: Numerisch berechnete räumliche Verteilung der resonanten Feldstärken: ko-axial, elektrisch (a), koaxial magnetisch (b), $TE_{01\delta}$ elektrisch (c), $TE_{01\delta}$ magnetisch.

Figur 3: Vorrichtung zur Identifikation von Flüssigkeiten in Flaschen mit einem Resonator nach Figur 1 und Messung mittels zweier Netzwerkanalysatoren.

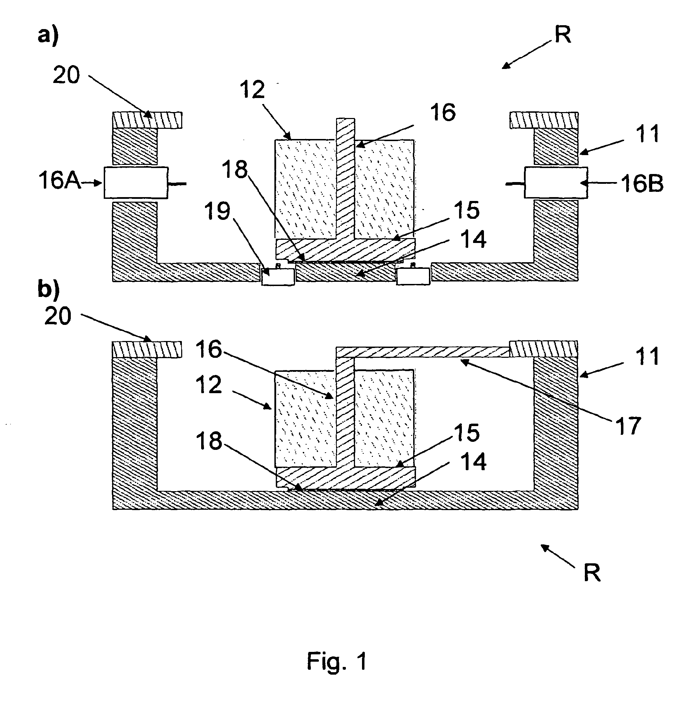

Figur 1a und Figur 1b zeigen zwei um 90° zueinander angeordnete Querschnitte einer erfindungsgemäßen Resonatoranordnung R mit LC-Schwingkreis und dielektrischen Resonator 12. Die Teile der Figuren sind maßstabsgetreu wiedergegeben.

Das kreiszylindrische Metallgehäuse 11 weist einen Durchmesser von etwa 60 Millimeter bei 2 GHz und 100 MHz auf. Es besteht aus versilbertem Aluminium oder aus Kupfer. Zentral im Gehäuse ist ein optionaler dielektrischer Resonator 12 gezeigt. Dieser umschließt, wie auch das Gehäuse 11, den darin angeordneten leitfähigen Stab 16 des LC-Schwingkreises koaxial. Ein Querbügel 17 (Figur 1b) als Kurzschlussstab verbindet das obere Ende des leitfähigen Stabs 16 radial mit dem Außengehäuse 11.

Ferner sind Einkoppelschleifen 16A und 16B zur Anregung der Mode des dielektrischen Resonators gezeigt.

Innerhalb des zylinderförmigen Metallgehäuses 11 mit hoher Leitfähigkeit wird auf der ebenen Bodenplatte 14 möglichst mittig ein metallischer Stempel 15, der mit dem möglichst zylinderförmigen Stab 16 leitend verbunden ist und vorzugsweise aus einem Stück gefertigt ist, angeordnet.

Die metallische Scheibe 15 aus einem gut leitenden Metall, wie z. B. Kupfer, wird mittels des Dielektrikum 18 aus Material mit hoher Dielektrizitätskonstante und geringen Verlusten von dem Gehäuseboden 14 getrennt, und bildet zusammen mit diesem und dem Dielektrikum einen Plattenkondensator aus. Das Dielektrikum besteht beispielsweise aus Saphir, Mikrowellenkeramiken, Kunstofffolien oder ist einfach durch einen Luftspalt gebildet und elektrisch vom Gehäuse 14 getrennt. Der zylinderförmige Metallstab 16 bildet einerseits den Innenleiter einer kurzen Koaxialleitung aus, anderseits die Zentrierung und Halterung für den kreiszylindrischen dielektrischen Resonator 12, der mit einer zum zylinderförmigen Stab 16 passenden zentralen Bohrung versehen ist. Am oberen Ende der Koaxialleitung wird der Innenleiter 16 (Figur 1b)) elektrisch leitend mit dem Gehäuse 11 verbunden, in der erfindungsgemäßen Anordnung durch einen radial nach außen verlaufenden Metallstab als Querbügel 17 hoher Leitfähigkeit, z. B. aus Kupfer. Die gesamte Anordnung aus Gehäuse, Bodenplatte, Dielektrikum, Stab und Querbügel stellt einen Koaxialresonator dar, der am elektrisch offenen Ende unten durch eine hohe Kapazität, und am elektrisch geschlossenen Ende oben, durch eine niedrige Induktivität abgeschlossen ist. Die Kombination aus hoher Kapazität und niedriger Induktivität ist der Schlüssel für hohe Güten bei niedrigen Frequenzen - im Gegensatz zu resonanten Spulen -, die im MHz-Bereich üblicherweise eingesetzt werden.

Die Resonanzfrequenz der Koaxialmode hängt von der Dicke des Dielektrikums 18 ab. Ist im Ausführungsbeispiel ein Luftspalt belassen, dessen Höhe z. B. durch Piezo-Aktuatoren (nicht dargestellt) von außen einstellbar ist, läßt sich die Resonanzfrequenz über eine extern angelegte Spannung variieren. Damit lässt sich die Selektivität für die Identifikation einer Probe weiter erhöhen.

Die Anregung einer $TE_{0m,n+\delta}$ Moden erfolgt durch koaxiale Schleifen 16A und 16B in der zylinderförmigen Seitenwand des Gehäuses 11, die Anregung der Koaxialmode durch Koaxialantennen 19, die in das hohe elektrische Feld des Kondensators eingebracht werden. In Figur 1 ist aufgrund der Kopplung, der Durchmesser der isolierenden Scheibe 18 gegenüber dem des Stempels 15 etwas kleiner gewählt, damit die Koaxialantennen 19 in den Luftspalt eintauchen können. Im Ausführungsbeispiel wird der Stempel 15, der Stab 16 und die Platte 18 durch eine Metallblende 20 bzw. durch Verschraubungen mit dem Gehäuseboden 14 fixiert.

Für jede der beiden Moden sind zwei Ankopplungen vorhanden, so dass die Resonanzkurven vorzugsweise im Transmissionsbetrieb durch jeweils einen Netzwerkanalysator oder durch einen Netzwerkanalysator mit integrierten Umschaltern gemessen werden können. Messungen im Reflektionsbetrieb an jeweils einer der Ankoppelungen sind ebenfalls möglich.

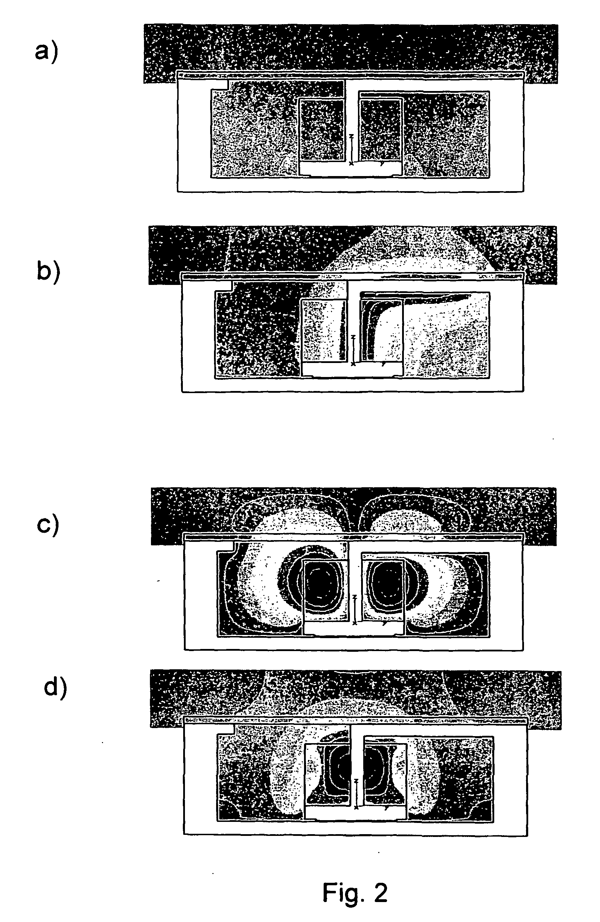

Figuren 2a) bis 2d) zeigen die numerisch berechneten räumlichen Verteilungen der elektrischen und magnetischen Felder für die Koaxialmode und die $TE_{01\delta}$ Mode (koaxial, elektrisch (Figur 2a), koaxial magnetisch (Figur 2b), $TE_{01\delta}$ elektrisch (Figur 2c), $TE_{01\delta}$ magnetisch (Figur 2d).

Aus diesen Berechnungen lassen sich für die Funktion des Resonators als Dual-Mode Sensors für Flüssigkeiten in geschlossenen Behältern folgende Schlüsse ziehen.

1) Die Feldverteilung und der Gütefaktor der $TE_{01\delta}$ Mode wird durch den Metallstempel 15, die isolierende Platte 18 und die Koppelantennen 19 für die koaxiale Mode nur sehr wenig beeinflusst. Lediglich der Kurzschlussstab 17 verursacht eine leichte lokale Deformation der Felder, die in Figur 2c und Figur 2d nicht sichtbar ist. Dies ist aufgrund der Tatsache zu verstehen, dass die elektrischen Felder der $TE_{01\delta}$ Mode kreisförmig verlaufen (Figur 2b)), also senkrecht zur Orientierung des Kurzschlussstabs. Aus diesem Grund kann die $TE_{01\delta}$ Mode zur Identifikation von Flüssigkeiten genutzt werden.

2) Das elektrische Feld der Koaxialmode (Figur 2a)) ist nahezu vollständig (heller Bereich) im Spalt zwischen Stempel 15 und Gehäuseboden 14 konzentriert, so dass der dielektrische Resonator 12 lediglich eine geringfügig Frequenz senkende Wirkung hat. Das Magnetfeld des Kurzschlussstabs (Figur 2b)) ragt in den Außenraum (heller Bereich), und kann für Leitfähigkeitmessungen benutzt werden.

3) Das elektrische Feld der $TE_{01\delta}$ Mode im Außenraum (Figur 2c - heller Bereich)) und das magnetische Feld der Koaxialmode (Figur 2b - heller Bereich)) überlappen evaneszent im Außenraum an einer Stelle, an der die Probe angeordnet ist. Dies erlaubt die Messung der Eigenschaften der Probe bei beiden Resonanzfrequenzen auch in geschlossenen Behältern in einer Position, ohne dass diese Position des Behälters gegenüber der Resonatoranordnung verändert werden muss.

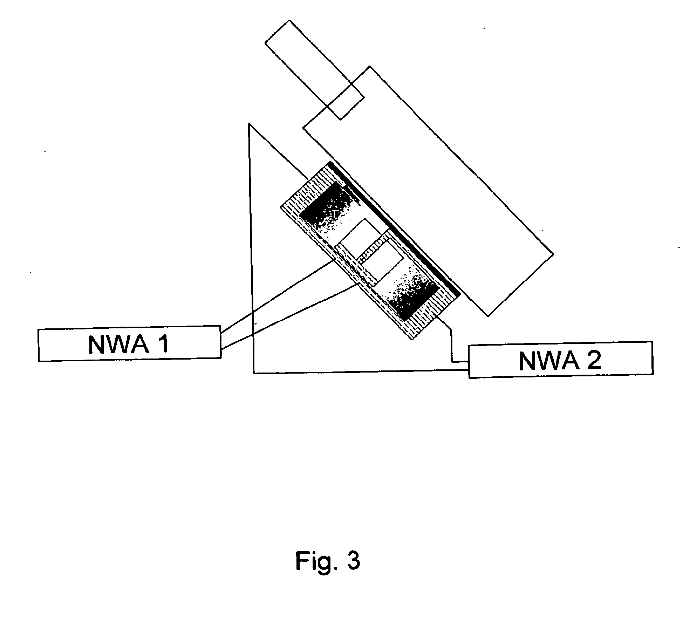

Figur 3 zeigt eine erfindungsgemäße Anordnung zur Nutzung der Resonatoranordnung mit Dual-Mode Resonator für die Identifikation einer Flüssigkeit in geschlossenen Behältern. Die Flasche wird seitlich und möglichst mittig auf eine Halteplatte des Resonators aufgelegt. Dabei wird die beste Ankopplung der Koaxialmode an die Flüssigkeit dann erzielt, wenn die Achse der Flasche parallel zum Kurzschlussstab 17 in Figur 1 liegt. Mit Hilfe der beiden Netzwerkanalysatoren NWA 1 und NWA 2 werden die durch die jeweilige Flasche erzeugten Änderungen von Güte und Resonanzfrequenz in den beiden Moden gemessen. Zur Analyse der Dielektrizitätskonstante mittels dielektrischen Resonator wird vorzugsweise das Verhältnis aus Änderung der Resonanzfrequenz zur Änderung der reziproken Güte verwendet. Für die Leitfähigkeitsmessungen kann die durch die Flasche verursachte Änderung der reziproken Güte der Koaxialmode verwendet werden.

Mit der beispielhaften Anordnung kann normales Leitungswasser von destilliertem Wasser deutlich unterschieden werden.

Anwendungen der erfindungsgemäßen Vorrichtung beziehen sich auf den Einsatz bei dem Nachweis von Proben in verschlossenen Behältern sowie dem Nachweis von Wasser, Fett, Salzgehalt, Säuregehalt in Geweben und anderen beispielsweise medizinischen Proben (Gewebe etc).

## Patentansprüche

**1.** Resonatoranordnung umfassend ein leitfähiges, halboffenes Außengehäuse, in dessen innern ein koaxial zum Gehäuse angeordnete leitfahiger Stab angeordnet ist, wobei der Stab an einem Ende in Richtung des Gehäusebodens einen Stempel aufweist und mit einem Dielektrikum und dem Gehäuseboden einen Kondensator ausbildet und der Stab am anderen Ende mit dem Gehäuse kurzgeschlossen ist, so dass Stab und Gehäuse gemeinsam einen LC-Schwingkreis auszubilden vermögen,
**dadurch gekennzeichnet, dass**
der leitfähige Stab durch einen dielektrischen Resonator im Innem des Gehäuses hindurchgeführt ist

**2.** Resonatoranordnung nach Anspruch 1,
mit Mitteln zur Anregung einer koaxialen Mode des LC-Schwingkreises und Mitteln zur Anregung der Moden des dieelelktrischen Resonators.

**3.** Resonatoranordnung nach einem der vorhergehenden Ansprüche,
**gekennzeichnet durch**
einen Querbügel, der den Stab radial mit dem Gehäuse kurzschileßt

**4.** Resonatoranordnung nach einem der vorhergehenden Ansprüche,
bei dem der dielektrische Resonator zur Bestimmung der dielektrischen Relaxation bei Frequenzen oberhalb 1 MHz und der kapazitiv abgeschlossene koaxiale Resonator zur Bestimmung der dielektrischen Leitfählgkelt bei Frequenzen zwischen 1 bis 600 GHz eingesetzt werden kann.

**5.** Resonatoranordnung nach einem der vorhergehenden Ansprache,
wobei der dielektrische Resonator zentriert in dem metallischen Gehause angeordnet ist und zusammen den Stab koaxial umschließt.

**6.** Resonatoranordnung nach einem der vorhergehenden Ansprüche,

**gekennzeichnet durch**
einen kreiszylindrischen dielektrischen Resonator.

7. Verfahren zur Analyse einer Probe mit einer Resonatoranordnung nach einem der vorhergehenden Ansprüche, wobei die Mode des LC-Schwingkrelses und des dielektrischen Resonators simultan angeregt werden und ein räumlich Oberlappendes evaneszentes Feld außerhalb der Resonatoranordnung für beide Moden am Ort der Probe erzeugt wird und die dielektrische Relaxation und die elektrische Leitfähigkeit zur Analyse der Probe simultan bestimmt werden.

8. Verfahren nach Anspruch 7,
**gekennzeichnet durch**
eine Anregungsfrequenz größer 1 GHz für den dielektrischen Resonator und eine Anregungsfrequenz im Bereich von 1 bis 500 MHz für den LC-Schwingkreis.

## Claims

1. A resonator assembly comprising a conductive, semi-open outer housing, inside which a conductive bar is disposed so as to be coaxial with the housing, the bar having a die at one end towards the floor of the housing and with a dielectric and the floor of the housing forming a capacitor, and the bar being shortcircuited to the housing at the other end so that bar and housing together are capable of forming an LC resonant circuit,
**characterized in that**,
inside the housing, the conductive bar is passed through a dielectric resonator.

2. A resonator assembly according to Claim 1,
with means for exciting a coaxial mode of the LC resonant circuit and means for exciting the modes of the dielectric resonator.

3. A resonator assembly according to one of the preceding claims,
**characterized by**
a transverse bridge which radially short-circuits the bar to the housing.

4. A resonator assembly according to one of the preceding claims, with which the dielectric resonator can be used for determining dielectric relaxation at frequencies above 1 GHz and the capacitively terminated coaxial resonator can be used for determining dielectric conductivity at frequencies between 1 and 500 MHz.

5. A resonator assembly according to one of the preceding claims, the dielectric resonator being positioned in the centre of the metal housing and coaxially enclosing the bar.

6. A resonator assembly according to one of the preceding claims,
**characterized by**
a circular cylindrical dielectric resonator.

7. A method of analyzing a sample using a resonator assembly according to one of the preceding claims, in which the modes of the LC resonant circuit and of the dielectric resonator are excited simultaneously and a spatially overlapping evanescent field is generated outside of the resonator assembly for both modes at the site of the sample, and the dielectric relaxation and electric conductivity are simultaneously determined for analysis of the sample.

8. A method according to Claim 7,
**characterized by**
an excitation frequency greater than 1 GHz for the dielectric resonator and an excitation frequency ranging between 1 and 500 MHz for the LC resonant circuit.

## Revendications

1. Ensemble résonateur comprenant un boîtier extérieur conducteur, demi-fermé, à l'intérieur duquel est disposé une tige conductrice disposée de manière coaxiale par rapport au boîtier, sachant que la tige présente, au niveau d'une extrémité, en direction du fond du boîtier, un poinçon et forme avec un diélectrique et le fond du boîtier un condensateur et sachant que la tige est court-circuitée avec le boîtier au niveau de l'autre extrémité, de sorte que la tige et le boîtier sont en mesure de réaliser conjointement un circuit oscillant LC,
**caractérisé en ce que**
la tige conductrice est guidée à travers un résonateur diélectrique à l'intérieur du boîtier.

**2.** Ensemble résonateur selon la revendication 1,
comprenant des moyens servant à exciter un mode coaxial du circuit oscillant LC et
des moyens servant à exciter des modes du résonateur diélectrique.

**3.** Ensemble résonateur selon l'une quelconque des revendications précédentes,
**caractérisé par**
un arceau transversal, qui court-circuite la tige radialement avec le boîtier.

**4.** Ensemble résonateur selon l'une quelconque des revendications précédentes,
dans le cadre duquel le résonateur diélectrique servant à déterminer la relaxation diélectrique peut être utilisé à des fréquences supérieures à 1 GHz et le résonateur coaxial fermé de manière capacitive servant à déterminer la conductivité diélectrique peut être utilisé à des fréquences comprises entre 1 et 500 MHz.

**5.** Ensemble résonateur selon l'une quelconque des revendications précédentes,
sachant que le résonateur diélectrique est disposé de manière centrée dans le boîtier métallique et entoure de manière coaxiale la tige.

**6.** Ensemble résonateur selon l'une quelconque des revendications précédentes,
**caractérisé par**
un résonateur diélectrique cylindrique circulaire.

**7.** Procédé servant à analyser un échantillon avec un ensemble résonateur selon l'une quelconque des revendications précédentes, sachant que le mode du circuit oscillant LC et le mode du résonateur diélectrique sont excités de manière simultanée, qu'un champ évanescent recouvrant spatialement est généré à l'endroit de l'échantillon en dehors de l'ensemble résonateur pour les deux modes, et que la relaxation diélectrique et la conductivité électrique sont déterminées de manière simultanée aux fins de l'analyse de l'échantillon.

**8.** Procédé selon la revendication 7,
**caractérisé par**
une fréquence d'excitation supérieure à 1 GHz pour le résonateur diélectrique et une fréquence d'excitation comprise dans la plage allant de 1 à 500 MHz pour le circuit oscillant LC.

a)
R
20
12
16
11
16A
16B
18
19
15
14
b)
20
16
11
12
17
18
15
14
R

Fig. 1

a)
b)
c)
d)

Fig. 2

NWA 1
NWA 2

Fig. 3

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- DE 102006046657 A1